Europäisches Patentamt

European Patent Office

Office européen des brevets

(11) Publication number: **0 031 663**
**B1**

# EUROPEAN PATENT SPECIFICATION

(45) Date of publication of patent specification: **03.04.85**

(51) Int. Cl.[4]: **H 01 J 29/45**

(21) Application number: **80304490.8**

(22) Date of filing: **12.12.80**

(54) Photoelectric device.

(30) Priority: **14.12.79 JP 161549/79**

(43) Date of publication of application:
**08.07.81 Bulletin 81/27**

(45) Publication of the grant of the patent:
**03.04.85 Bulletin 85/14**

(84) Designated Contracting States:
**DE FR GB NL**

(56) References cited:
**EP-A-0 032 847**
**EP-A-0 039 219**
**FR-A-2 331 887**
**US-A-3 800 194**

**APPLIED PHYSICS LETTERS; vol. 35, August 1979 New York, US Y. IMAMURA et al. "Photoconductive imaging using hydrogenated amorphous silicon film" pages 349-351**

(73) Proprietor: **Hitachi, Ltd.**
**5-1, Marunouchi 1-chome**
**Chiyoda-ku Tokyo 100 (JP)**

(72) Inventor: **Imamura, Yoshinori**
**2-32-C207, Koyasu-cho**
**Hachioji-shi Tokyo (JP)**
Inventor: **Tanaka, Yasuo**
**1-217-AI, Higashi-koigakubo**
**Kokubunji-shi Tokyo (JP)**
Inventor: **Ataka, Saburo**
**2196-195, Hirai Hinodemachi**
**Nishitama-gun Tokyo (JP)**
Inventor: **Hirai, Tadaaki**
**1-6-12, Sakura-cho**
**Koganei-shi Tokyo (JP)**
Inventor: **Takasaki, Yukio**
**1-47-1-D401, Akatsuki-cho**
**Hachioji-shi Tokyo (JP)**
Inventor: **Maruyama, Elichi**
**1572-3, Josuihoncho**
**Kodaira-shi Tokyo (JP)**

(74) Representative: **Paget, Hugh Charles Edward et al**
**MEWBURN ELLIS & CO. 2/3 Cursitor Street London EC4A 1BQ (GB)**

**Description**

This invention relates to a photoelectric device which is used in the storage mode, and more particularly to the structure of a photosensitive panel which can be employed for the photoconductive target of an image tube, etc.

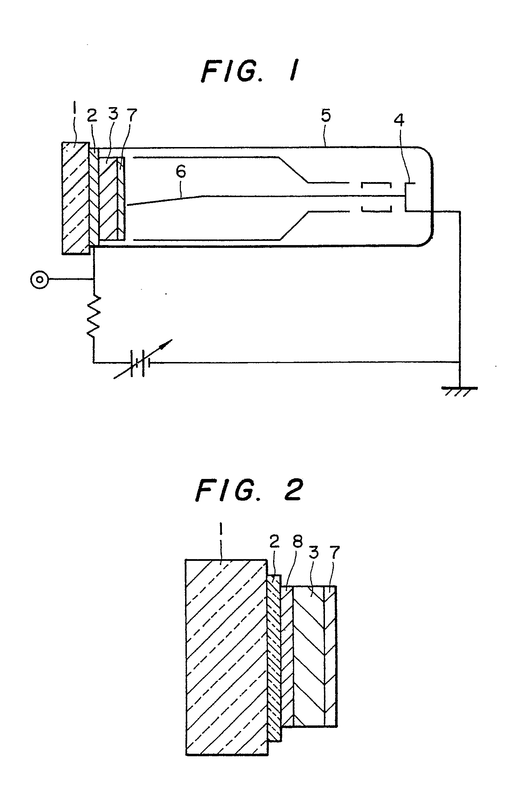

As a typical example of a photoelectric device which is used in the storage mode, a photoconductive image tube is shown in Figure 1. It is constructed of a light-transmitting substrate 1 usually termed a "faceplate", a transparent conductive film 2 serving as a signal electrode, a photoconductor layer 3, an electron gun 4, and an envelope 5. In operation, an optical image formed on the photoconductor layer 3 through the faceplate 1 is photoelectrically converted and is stored as a charge pattern in the surface of the photoconductor layer 3, and the charge pattern is read in time sequence by a scanning electron beam 6.

Ordinarily, a beam landing layer 7 is disposed on the surface of the photoconductor layer 3 for the purposes of preventing inversion of the polarity of the surface charges, blocking the injection of electrons from the scanning electron beam, and so forth.

An important property required of the photoconductor layer 3 at this time is that the charge pattern does not decay due to diffusion within the time interval in which a specified picture element is scanned by the scanning electron beam 6 (i.e. within the storage time).

Examples of such photoconductive targets are described in:

U.S. Patent No. 3346755

U.S. Patent No. 3350595.

The use of amorphous silicon for the photoconductor layer 3 is described in, for example British Specification 1349351 (E.M.I. Limited).

In a photoelectric device having a photoelectric portion which employs as a photoelectric material an amorphous material including silicon as its principal constituent and containing hydrogen and in which the amorphous photoelectric material and a signal electrode form a rectifying contact type structure, there is a problem in providing a photosensitive panel capable of suppressing dark current satisfactorily, particularly when an intense electric field is applied across a junction interface.

In this invention, a layer of an inorganic material whose principal constituent is one or more of the oxides, nitrides or halides mentioned below is interposed between a signal electrode and a photoconductor layer made of an amorphous material including silicon as its principal constituent and containing hydrogen.

(1) Oxides

Oxides of at least one of the following elements: Si, Ti, Al, Mg, Ba, Ta, Bi, V, Ni, Th, Fe, La, Be, Sc and Co.

Particular examples are as follows: $SiO_2$, $TiO_2$, $Al_2O_3$, $MgO$, $BaO$, $Ta_2O_5$, $Bi_2O_3$, $V_2O_5$, $NiO$, $ThO_2$, $Fe_2O_3$, $La_2O_3$, $BeO$, $Sc_2O_3$, $Co_2O_3$ and eutectics.

(2) Nitrides

Nitrides of at least one of the following elements: Ga, Si, Mg, Ta, Hf, Zr, Nb and B.

Particular examples are as follows: $GaN$, $Si_3N_4$, $Si_2N_3$, $MgN_2$, $TaN$, $HfN$, $ZrN$, $NbN$, $BN$ and eutectics.

(3) Halides

Halides of at least one of the following elements: Na, Mg, Li, Ba, Ca and K.

Particular examples are as follows: $MgF_2$, $LiF$, $NaF$, $BaF_2$, $CaF_2$, $KF$ and eutectics.

It is also possible to employ a layer of a mixture consisting of the aforecited materials, stacked layers of the aforecited materials, etc.

Among the materials listed above, the following ones are particularly preferable, since they are most effective in suppressing dark current.

(1) Oxides of Si, Ba, Ta, Ti or Al.

(2) Nitrides of Si or Ta.

(3) Halides of Li or Mg.

Further, $SiO_2$, $Al_2O_3$, $Ta_2O_5$, $Si_3N_4$, $TaN$, $LiF$, $MgF_2$ and any mixture of these compounds are chemically stable and are especially favorable materials.

In the accompanying drawings:

Figure 1 is a view showing the structure of an image tube,

Figure 2 is a sectional view showing the structure of a photoelectric device according to this invention, and

Figure 3 is a graph showing the relationships of the photocurrent and the dark current to the target voltage in the photoelectric device of Figure 2 in comparison with a known device.

The preferred embodiments of the invention will now be described.

The use of an amorphous material including silicon as its principal constituent and containing hydrogen for a photoconductor layer as in the invention of the present Application has been proposed, and has previously been disclosed in Applied Physics Letters, vol. 35, Aug. 1979, New York pages 349 to 351, "Photoconductive imaging using hydrogenated amorphous silicon film.

The amorphous material whose principal constituent is silicon and which contains hydrogen will be described.

The photoconductor film is formed of a single layer or stacked layers. In general, the single layer of a photoconductive substance or at least one of the stacked layers is made of amorphous material which contains at least 50 atomic-% of silicon and at least 5 atomic-% to at most 50 atomic-% of hydrogen and whose resistivity is at least $10^{10} \Omega \cdot cm$. Alternatively, a material in which at least 0.1 atomic-% to at most 50 atomic-% of the silicon atoms of the above photoconductor layer is substituted with germanium atoms can be employed. Ordinarily, the photoconductor film has its thickness within a range of 100 nm to 20 μm.

The photoconductive materials used in this invention may be produced by various methods. Hereunder, typical examples will be described.

The first method is by reactive sputtering.

As a target for sputtering, a slice of fused silica may be employed. Of course, single-crystal and polycrystalline silicon may also be employed. In case of the amorphous material containing silicon and germanium, a target in which these two group-IV elements are combined is used. In this case, it is convenient to construct the target by, for example, placing a foil of germanium on a substrate of silicon. By properly selecting the ratio between the areas of silicon and germanium, the composition of the amorphous material can be controlled. Of course, it is also possible to dispose a silicon foil on a germanium substrate. Further, both the substances may well be juxtaposed to construct the target, or a melt of the composition may well be used.

When Si containing phosphorus (P), arsenic (As), boron (B) etc. in advance is used as the target for sputtering, these elements can be introduced as impurity elements. With this method, an amorphous material having any desired conductivity type such an n-type or p-type can be obtained. Such doping with impurity makes it possible to vary the resistance value of the material. Even a high resistivity of the order of $\sim 10^{13} \Omega \cdot cm$ can be realised. A method in which diborane or phosphine is mixed into a rare gas can also be employed for such doping with the impurity.

Using the means as stated above, in an Ar atmosphere containing hydrogen ($H_2$) at any of various mixing ratios of at most 90 mol-%, a radio-frequency discharge is generated to sputter Si and deposit into the substrate, whereby a thin layer can be formed. In this case, the pressure of the Ar atmosphere containing hydrogen may be any within a range in which the glow discharge can be sustained, and it is usually 0.001—1.0 Torr or so. In the range 0.001—0.1 Torr, the discharge is especially stable. The temperature of the sample substrate is preferably between room temperature and 300°C. 150—250°C are the most practical. At too low a temperature, it is difficult to introduce hydrogen into the amorphous material conveniently, and conversely, at too high a temperature, hydrogen tends to be emitted from the amorphous material. The hydrogen content of the amorphous material is controlled by controlling the partial pressure of hydrogen in the Ar atmosphere. If the quantity of hydrogen in the atmosphere is made 20—80 mol-%, a content of approximately 30 atomic-% can be realised in the amorphous material. To produce other compositions, a rough standard is to set the partial pressure of hydrogen proportionately to this. The hydrogen components in the materials may be quantified by using mass spectroscopy on the hydrogen gas produced by heating.

The argon atmosphere can be replaced with another rare gas such as Kr.

In obtaining a film of high resistivity, a low-temperature high-speed sputtering equipment of the magnetron type is preferred.

The second method of producing the amorphous materials is to employ a glow discharge. The amorphous material is formed by performing a glow discharge of $SiH_4$ to decompose an organic substance and deposit its constituent onto a substrate. The glow discharge may be caused either by the D.C. bias method or by the radio-frequency discharge method. In order to obtain an amorphous material of particularly good quality, the temperature of the substrate needs to be held at 200°C—400°C.

An amorphous material of the p-type or the n-type can be produced by further mixing 0.1—1% (volumetric ratio) of $B_2H_6$ or the like or $PH_3$ or the like into a mixed gas consisting of $SiH_4$ and $CH_4$, respectively. The amorphous films can also be formed by electron-beam evaporation in an atmosphere containing $H_2$.

The inorganic materials to be disposed between the photoconductor layer and the signal electrode are as described before. Principal preferred materials are summed up as Table 1. In the table, the materials have been divided into three classes in accordance with their effects on dark current.

TABLE 1

| Characteristics / Materials | Dark current (Target voltage $V_T$=50V) (Relative value) | | |
|---|---|---|---|
| | 1 | 1—2 | 2—10 |
| Oxides | $SiO_2$, BaO, $Ta_2O_5$, $TiO_2$, $Al_2O_3$ | MgO, $V_2O_5$, NiO, $Fe_2O_3$, $Co_2O_3$ | $Bi_2O_3$, $ThO_2$, $La_2O_3$, BeO, $Sc_2O_3$ |
| Nitrides | $Si_3N_4$, TaN | GaN, $Si_2N_3$, $MgN_2$ | HfN, ZrN, NbN, BN |
| Halides | LiF, $MgF_2$ | $BaF_2$, $CaF_2$, NaF, KF | |

As apparent from the table, $SiO_2$, BaO, $TiO_2$, $Ta_2O_5$ and $Al_2O_3$ among oxides, $Si_3N_4$ and TaN among nitrides and LiF and $MgF_2$ among halides have especially excellent characteristics. The next most favorable characteristics are those of MgO, $V_2O_5$, NiO, $Fe_2O_3$ and $Co_2O_3$ among oxides, GaN, $Si_2N_3$ and $MgN_2$ among nitrides and $BaF_2$, $CaF_2$, NaF and KF. Favorable characteristics are also shown by $Bi_2O_3$, $ThO_2$, $La_2O_3$, BeO and $Sc_2O_3$ among oxides, and HfN, ZrN, NbN and BN.

$SiO_2$, $Al_2O_3$, $Ta_2O_5$, $Si_3N_4$, TaN, LiF and $MgF_2$ are chemically stable, and are therefore very favorable. The reason is that the photoconductor which overlies the layer of the inorganic material is the material containing hydrogen. More specifically, during the formation of the photoconductor, the inorganic material is exposed to the atmosphere containing hydrogen and is liable to be reduced. In order to form a photoconductor layer of good quality, the substrate temperature is held at 200°C—400°C as stated before, which further increases the likelihood of reduction. While a change in the material property affects particularly the photo current and dark current characteristics, the aforecited materials ($SiO_2$ etc.) are substantially free from such problems.

The thickness of the inorganic material layer is made 50 Å—5,000 Å or so. Especially when it is made 1,000 Å or less, the transmission of incident light decreases little, and it is unnecessary to fear that the sensitivity of the photoelectric device will lower.

Usually, it is very favorable to form the foregoing oxide layer by means of sputtering evaporation, employing an oxide identical to that of the layer as the evaporation source material.

The sputtering evaporation ordinarily uses a radio-frequency discharge in Ar gas under $1\times10^{-1}$ Torr to $1\times10^{-3}$ Torr. If the oxide is liable to be reduced and to blacken, at most about 5 volume -% of oxygen may be mixed in the Ar gas.

While the substrate temperature during the evaporation may be 25°C—400°C, a value of 100°C—250°C is favorable for forming a film which is closely adherent to the substrate and whose smoothness is good.

The thin layer of any of the foregoing oxides, nitrides and halides is interposed between the photoconductive film and the signal electrode. However, it need not always adjoin the signal electrode, but a layer made of another material may well intervene between the signal electrode and the thin layer described above. The photoconductive film and the oxide should, however, adjoin each other.

Example 1

As shown in Figure 2, a transparent electrode 2 (serving as a signal electrode) made of $SnO_2$ was formed on a glass substrate 1. The resultant substrate was installed on a substrate holder electrode in a radio-frequency sputtering equipment. On the other hand, an $SiO_2$ target was installed on a target electrode. Subsequently, the sputtering chamber was evacuated to a pressure of below $5\times10^{-6}$ Torr, whereupon Ar gas was introduced thereinto so as to establish a gaseous pressure of $1.0\times10^{-2}$ Torr.

Under this gaseous pressure, a radio-frequency discharge at a frequency of 13.56 MHz and a power of 1 W/cm$^2$ was caused across the two electrodes, to form an $SiO_2$ thin film 8 on the transparent electrode 2 to a thickness of approximately 250 Å.

Subsequently, a sintered compact of silicon at a purity of 99.999% was installed on the target electrode of the radio-frequency sputtering equipment, and an amorphous silicon film 3 was formed on the $SiO_2$ thin film 8 by reactive sputtering in a mixed atmosphere which consisted of Ar under $1\times10^{-3}$ Torr and hydrogen under $2\times10^{-3}$ Torr. In this case, the substrate was held at 250°C. The amorphous silicon film thus formed contained approximately 20 atomic-% of hydrogen, and had a resistivity of $10^{14}\Omega \cdot$ cm.

The $SiO_2$ thin film 8 can be formed by electron-beam evaporation instead of by the sputtering

4

described above. An SiO$_2$ film formed by electron-beam evaporation exhibits a dark current-suppressing effect to the same extent as that of the SiO$_2$ film formed by sputtering. In general, however, evaporated films have less adhesion to the substrate than sputtered films, so that the former sometimes exfoliates from the substrate when the amorphous silicon is deposited thereon.

Lastly, as a beam landing layer for improving the landing characteristics of an electron beam, an Sb$_2$S$_3$ film 7 was evaporated in an Ar gas pressure to a thickness of approximately 1,000 Å.

The beam landing layer is conventional in image tubes.

An image tube target prepared by the method described above had dark currents suppressed to sufficiently low magnitudes even at high target voltages.

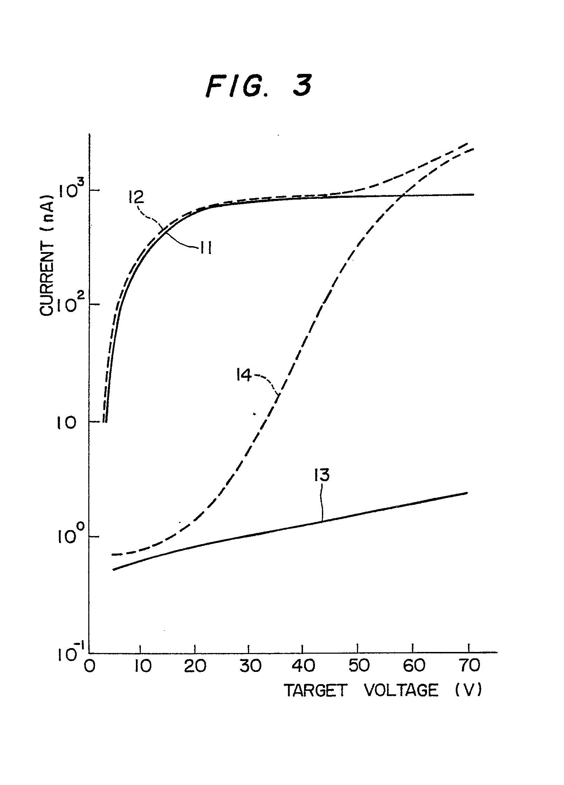

Figure 3 is a graph showing measured results on photo current and the dark current component in the photo current versus target voltage. Numerals 11 and 13 respectively indicate the photo current and the dark current component in the photo current in an image tube which adopted this invention, while numerals 12 and 14 respectively indicate the photo current and the dark current component in an image tube which did not employ the SiO$_2$ film according to this invention. It is understood from this figure that the present invention is very greatly effective to suppress the dark current.

Example 2

A transparent electrode made of In$_2$O$_3$ was formed on a glass substrate, and any of various thin films listed in the following Table 2 was formed thereon by sputtering evaporation in accordance with the same method as in Example 1. Further, a silicon layer containing 15 atomic-% of hydrogen was formed by reactive sputtering to a thickness of 2 μm.

In forming the hydrogen-containing amorphous silicon film corresponding to each of the samples other than the Al$_2$O$_3$ film, the temperature of the substrate was set as follows. The substrate temperature was held at the normal temperature at the initiation of the formation of the silicon film, and it was raised to a predetermined value with the deposition of the film. This measure was taken in order to prevent reduction by hydrogen in the atmosphere as stated before. The silicon film formed served as a protective film. The characteristics of the photoconductor are somewhat inferior, but can be put into practical use.

Lastly, an Sb$_2$O$_3$ film was evaporated in an Ar gas pressure, to produce a finished target for an image tube. As indicated in Table 2, favorable characteristics similar to those in Example 1 were exhibited.

TABLE 2

| | Ar gas pressure (Torr) | Radio frequency power (W/cm$^2$) | Thickness (Å) | Dark current (nA) |
|---|---|---|---|---|
| TiO$_2$ | $4 \times 10^{-2}$ | 1 | 500 | 1.2 |
| BaO | $5 \times 10^{-3}$ | 1.5 | 250 | 1.2 |
| Ta$_2$O$_3$ | $5 \times 10^{-3}$ | 2 | 200 | 1.4 |
| Al$_2$O$_3$ | $3 \times 10^{-2}$ | 1.5 | 200 | 1.5 |
| MgO | $2.5 \times 10^{-3}$ | 0.5 | 300 | 4.0 |
| V$_2$O$_5$ | $5 \times 10^{-3}$ | 2 | 300 | 2.5 |
| La$_2$O$_3$ | $2 \times 10^{-3}$ | 1 | 300 | 9.5 |

$V_T = 50V$

Similar effects are achieved with a multilayered film in which SiO$_2$ and at least one of the above-mentioned materials are stacked with each thin layer being several tens Å thick (for example, when SiO$_2$ and Al$_2$O$_3$ are stacked).

Example 3

A transparent electrode made of SnO$_2$ was formed on a glass substrate, and was overlaid with any of various thin films listed in Table 3 by sputtering, decomposition by glow discharge, vacuum evaporation, or electron-beam evaporation. Further, an amorphous silicon layer containing 15 atomic-% of hydrogen was formed by reactive sputtering to a thickness of 2 μm. Lastly, an Sb$_2$S$_3$ film was evaporated in an Ar gas pressure, to produce a finished target for an image tube. As indicated in Table 3, favorable characteristics similar to those in Example 1 were exhibited.

TABLE 3

$V_T$=50V

| | Method of forming a blocking layer | Thickness (Å) | Dark current (nA) |
|---|---|---|---|
| $Si_3N_4$ | Decomposition by glow discharge | 500 | 1.2 |
| TaN | Reactive sputtering | 150 | 1.8 |
| LiF | Vacuum evaporation | 150 | 1.0 |
| $MgF_2$ | Electron-beam evaporation | 200 | 1.5 |
| GaN | Reactive sputtering | 250 | 3.5 |
| $MgN_2$ | Reactive sputtering | 300 | 4.5 |
| $CaF_2$ | Electron-beam evaporation | 200 | 4.0 |
| BaF | Electron-beam evaporation | 250 | 5.0 |
| ZrN | Reactive sputtering | 300 | 14.0 |
| NaF | Vacuum evaporation | 200 | 13.0 |

## Claims

1. A photoelectric device having at least a signal electrode, and an amorphous photoconductor layer whose principal constituent is silicon and which contains hydrogen, the amorphous photoconductor layer being disposed adjacent to the signal electrode; characterised in that a thin layer is interposed between said signal electrode and said amorphous photoconductor layer, said thin layer being made of an inorganic material whose principal constituent is at least one of the following compounds: an oxide of at least one of the elements Si, Ti, Al, Mg, Ba, Ta, Bi, V, Ni, Th, Fe, La, Be, Sc and Co; a nitride of at least one of the elements Ga, Si, Mg, Ta, Hf, Zr, Nb and B; or a halide of at least one of the elements Na, Mg, Li, Ba, Ca and K.

2. A photoelectric device according to claim 1, wherein said inorganic material includes as its principal constituent at least one of the following compounds: $SiO_2$, $TiO_2$, $Al_2O_3$, $MgO$, $BaO$, $Ta_2O_5$, $Bi_2O_3$, $V_2O_5$, $NiO$, $ThO_2$, $Fe_2O_3$, $La_2O_3$, $BeO$, $Sc_2O_3$, $Co_2O_3$, $GaN$, $Si_3N_4$, $Si_2N_3$, $MgN_2$, $TN$, $HfN$, $ZrN$, $NbN$, $BN$, $MgF_2$, $LiF$, $NaF$, $BaF_2$, $CaF_2$, $KF$, and eutectics thereof.

3. A photoelectric device according to claim 1, wherein said inorganic material of said thin layer includes as its principal constituent at least one of the following compounds: an oxide of at least one of the elements Si, Ba, Ta, Ti and Al, a nitride of at least one of the elements Si and Ta, or a halide of at least one of the elements Li and Mg.

4. A photoelectric device according to claim 1, wherein said inorganic material of said thin layer includes at least one of the compounds $SiO_2$, $Al_2O_3$, $BaO$, $Ta_2O_5$, $TiO_2$, $Si_3N_4$, $TaN$, $LiF$ and $MgF_2$.

5. A photoelectric device according to any one of claims 1 to 4, wherein said thin layer made of said inorganic material has a thickness of 50 Å to 5,000 Å.

6. A photoelectric device according to any one of claims 1 to 5, further comprising a light-transmitting substrate, on which said signal electrode is disposed, the surface of said substrate which is opposite to said signal electrode constituting a light receiving surface.

7. A photoelectric device according to any one of claims 1 to 6, further comprising a beam landing layer on the surface of the photoconductor layer opposite said thin layer of inorganic material.

## Patentansprüche

1. Photoelektrische Vorrichtung mit mindestens einer Signalelektrode und einer amorphen Photoleiterschicht, deren Haputbestandteil Silizium ist und die Wasserstoff enthält, wobei die amorphe Photoleiterschicht der Signalelektrode benachbart angeordnet ist, dadurch gekennzeichnet, daß zwischen die Signalelektrode und die amorphe Photoleiterschicht eine dünne Schicht eingefügt, ist, die aus einem

6

anorganischen Material besteht, dessen Hauptbestandteil mindestens eine der folgenden Verbindungen ist: ein Oxid mindestens eines der Elemente, Si, Ti, Al, Mg, Ba, Ta, Bi, V, Ni, Th, Fe, La, Be, Sc und Co; ein Nitrid mindestens eines der Elemente Ga, Si, Mg, Ta, Hf, Zr, Nb und B; oder ein Halogenid mindestens eines der Elemente Na, Mg, Li, Ba, Ca und K.

2. Photoelektrische Vorrichtung nach Anspruch 1, wobei das anorganische Material als Hauptbestandteil mindestens eine der folgenden Verbindungen enthält: $SiO_2$, $TiO_2$, $Al_2O_3$, MgO, BaO, $Ta_2O_5$, $Bi_2O_3$, $V_2O_5$, NiO, $ThO_2$, $Fe_2O_3$, $La_2O_3$, BeO, $Sc_2O_3$, $Co_2O_3$, GaN, $Si_3N_4$, $Si_2N_3$, $MgN_2$, TaN, HfN, ZrN, NbN, BN, $MgF_2$, LiF, NaF, $BaF_2$, $CaF_2$, KF und Eutektika davon.

3. Photoelektrische Vorrichtung nach Anspruch 1, wobei das anorganische Material der dünnen Schicht als Hauptbestandteil mindestens eine der folgenden Verbindungen enthält: ein Oxid mindestens eines der Elemente Si, Ba, Ta, Ti und Al, ein Nitrid mindestens eines der Elemente Si und Ta, oder ein Halogenid mindestens eines der Elemente Li und Mg.

4. Photoelektrische Vorrichtung nach Anspruch 1, wobei das anorganische Material der dünnen Schicht mindestens eine der Verbindungen $SiO_2$, $Al_2O_3$, BaO, $Ta_2O_5$, $TiO_2$, $Si_3N_4$, TaN, LiF und $MgF_2$ enthält.

5. Photoelektrische Vorrichtung nach einem der Ansprüche 1 bis 4, wobei die dünne Schicht aus dem anorganischen Material eine Dicke von 50 Å bis 5000 Å aufweist.

6. Photoelektrische Vorrichtung nach einem der Ansprüche 1 bis 5, ferner umfassen ein lichtdurchlässiges Substrat, auf dem die Signalelektrode angeordnet ist, wobei die der Signalelektrode entgegengesetzte Oberfläche des Substrats eine Lichtaufnahmefläche bildet.

7. Photoelektrische Vorrichtung nach einem der Ansprüche 1 bis 6, ferner umfassend eine Strahlauffangschicht auf der der dünnen Schicht aus anorganischem Material entgegengesetzten Oberfläche der Photoleiterschicht.

## Revendications

1. Dispositif photoélectrique comportant au moins une électrode de transmission de signal et une couche photoconductrice amorphe dont le composant principal est du silicium et qui contient de l'hydrogène, la couche photoconductrice amorphe étant disposée à proximité de l'électrode constituant le signal, caractérisé en ce qu'une couche mince est interposée entre ladite électrode de transmission de signal et ladite couche photoconductrice amorphe, cette couche mince étant constituée en un matériau inorganique dont le composant principal est au moins l'un des composés suivants: un oxyde d'au moins l'un des éléments Si, Ti, Al, Mg, Ba, Ta, Bi, V, Ni, Th, Fe, La, Be, Sc, et Co, un nitrure d'au moins l'un des éléments Ga, Si, Mg, Ta, Hf, Zr, Nb et B ou un halogénure d'au moins l'un des éléments Na, Mg, Li, Ba, Ca et K.

2. Dispositif photoélectrique selon la revendication 1, dans lequel ledit matériau inorganique inclut, comme composant principal, au moins l'un des composés suivants: $SiO_2$, $TiO_2$, $Al_2O_3$, MgO, BaO, $Ta_2O_5$, $Bi_2O_3$, $V_2O_5$, NiO, $ThO_2$, $Fe_2O_3$, $La_2O_3$, BeO, $Sc_2O_3$, $Co_2O_3$, GaN, $Si_3N_4$, $Si_2N_3$, $MgN_2$, TaN, HfN, ZrN, NbN, BN, $MgF_2$, LiF, NaF, $BaF_2$, $CaF_2$, KF et des eutectiques de ces composés.

3. Dispositif photoélectrique selon la revendication 1, dans lequel ledit matériau inorganique de ladite couche mince comporte comme composant principal au moins l'un des composés suivants: un oxyde d'au moins l'un des éléments Si, Ba, Ta, Ti et Al, un nitrure d'au moins l'un des éléments Si et Ta ou un halogénure d'au moins l'un des éléments Li et Mg.

4. Dispositif photoélectrique selon la revendication 1, dans lequel ledit matériau inorganique de ladite couche mince contient au moins l'un des composés: $SiO_2$, $Al_2O_3$, BaO, $Ta_2O_5$, $TiO_2$, $Si_3N_4$, TaN, LiF et $MgF_2$.

5. Dispositif photoélectrique selon l'une quelconque des revendications 1 à 4, dans lequel ladite couche mince est constituée par ledit matériau inorganique possède une épaisseur comprise entre 50 Å et 5000 Å.

6. Dispositif photoélectrique selon l'une quelconque des revendications 1 à 5, comportant en outre un substrat transparent pour la lumière et sur lequel l'électrode de transmission de signal est disposée, la surface dudit substrat située à l'opposé de ladite électrode de transmission de signal constituant une surface de réception de la lumière.

7. Dispositif photoélectrique selon l'une quelconque des revendications 1 à 6, comprenant en outre une couche d'impact du faisceau située à la surface de la couche photoconductrice, à l'opposé de ladite couche mince du matériau inorganique.

## FIG. 1

## FIG. 2

# FIG. 3